# EUROPEAN PATENT SPECIFICATION

(11) **EP 2 919 571 B1**
(45) Date of publication and mention of the grant of the patent: **27.12.2017**
(21) Application number: 14159248.5
(22) Date of filing: 12.03.2014
(51) Int. Cl.: H05K 7/20

(54) **ARRANGEMENT FOR SUBSEA COOLING OF ELECTRIC EQUIPMENT**
ANORDNUNG ZUR UNTERWASSERKÜHLUNG VON ELEKTRISCHER AUSRÜSTUNG
AGENCEMENT DE REFROIDISSEMENT SOUS-MARINE D'ÉQUIPEMENT ÉLECTRIQUE

(43) Date of publication of application: 16.09.2015
(73) Proprietor: ABB Schweiz AG, 5400 Baden (CH)
(72) Inventor: Schlegel, Christoph, 5405 Baden-Dättwil (CH); Petersson, Linnea, 723 34 Västerås (SE); Derbaix, Albert, 1170 Brussels (BE)
(74) Representative: Savela, Reino Aleksi

(56) References cited:
- EP-A1- 1 998 344
- EP-A1- 2 487 327
- EP-A1- 2 666 956
- WO-A1-2008/055515

## Description

### TECHNICAL FIELD

The invention relates to cooling arrangements, and particularly to arrangements for subsea cooling of electric equipment, and to a subsea power conversion unit comprising such an arrangement.

### BACKGROUND

In general terms, electric subsea installations and devices usually demand high standards regarding durability, long-term functionality and independence during operation. Electric subsea installations that need to be cooled during operation, such as subsea converters, require an autonomous and durable cooling of its components. It is known to use a dielectric liquid such as for example an oil as a cooling fluid. In general, electric subsea installations need to be pressurized with the dielectric fluid, thus said fluid, which is preferably a liquid, should be, at least almost, incompressible. In general terms, the dielectric liquid thus is used to provide an incompressible medium and additionally as an electric insulation medium of components, such as capacitor units, placed in the electric installation.

One difference between onshore and subsea locations of electrical installations is the increased pressure. Some electrical installations are aimed for implementations at locations at maximum 5000 meters depth, which gives a pressure of 500 bars. In order to reduce the footprint of the electrical installations in such subsea systems and to improve its cooling capabilities, the electrical installations needs to be pressure compensated. Pressure compensated systems can have thinner wall thickness. Non-pressure compensated systems (and components) need to have quite substantial wall thickness at such depths in order not to implode (in the absence of a thick wall around the non-pressure compensated system).

For pressure compensated systems, the whole container enclosing the components of the subsea power system is filled with a dielectric liquid. Subsea power systems that are fully pressurized need to be filled with a liquid which in general terms is substantially incompressible.

EP 1998344 A1 refers to an electronic component for application in high pressure environments comprising a casing entirely filled with an electrically insulating first fluid, whereby the casing exhibits or connects to a volume compensation unit for compensating a volume change of the first fluid.

EP 2666956 A1 deals with a modular electric device located under water and operating under high pressure in water environment at large depths, in which electric and power electronic systems are protected against the mechanical effect of high pressure, applicable to energizing induction motors driving rotating machinery.

EP 2487327 A1 provides a subsea electronic system. The system comprises a water tight enclosure adapted to enable an operation of the system under water. A heat generating electronic component is arranged in the enclosure. The electronic component generates heat in operation. The enclosure is at least partially filled with a dielectric liquid in which the electronic component is at least partially submerged. A heat sink is arranged on a wall of the enclosure and thermally coupled thereto.

Submerging components in a dielectric liquid is a challenge for many components, while there are already a number of power capacitor designs with a liquid filling. As such, for components such as capacitors one challenge is the pressure compensation to the outside and the pressure tolerance itself. Hence there is still a need for improved subsea cooling of electric equipment in subsea applications.

### SUMMARY

An object of embodiments herein is to provide efficient mechanisms for subsea cooling of electric equipment in subsea applications.

A particular object of embodiments herein is to provide efficient mechanisms for subsea cooling of electric equipment in subsea applications where the electric equipment comprises at least one capacitor unit. In accordance with the invention, an arrangement for subsea cooling of electric equipments as set forth in claim 1 is provided. Further embodiments are inter alia disclosed in the dependent claims. Particularly, according to a first aspect there is presented an arrangement for subsea cooling of electric equipment. The arrangement comprises a tank. The tank is filled with a first dielectric fluid. The first dielectric fluid is pressurized to a pressure closer to ambient sea water pressure than to atmospheric pressure. The arrangement comprises a housing. The housing has a surface area and a volume. The surface area to volume ratio is greater than 0.02 1/m. The housing is provided in the tank. The housing comprises a capacitor unit and is filled with a second dielectric fluid.

Advantageously, this enables efficient subsea cooling of electric equipment, such as capacitor units, in subsea applications.

According to a second aspect there is presented a subsea power conversion unit comprising an arrangement according to the first aspect. Advantageously, this enables in-house capacitor units to be supplied for subsea power conversion units.

It is to be noted that any feature of the first or second aspects may be applied to any other aspect, wherever appropriate. Likewise, any advantage of the first aspect may equally apply to the second aspect, and vice versa. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:

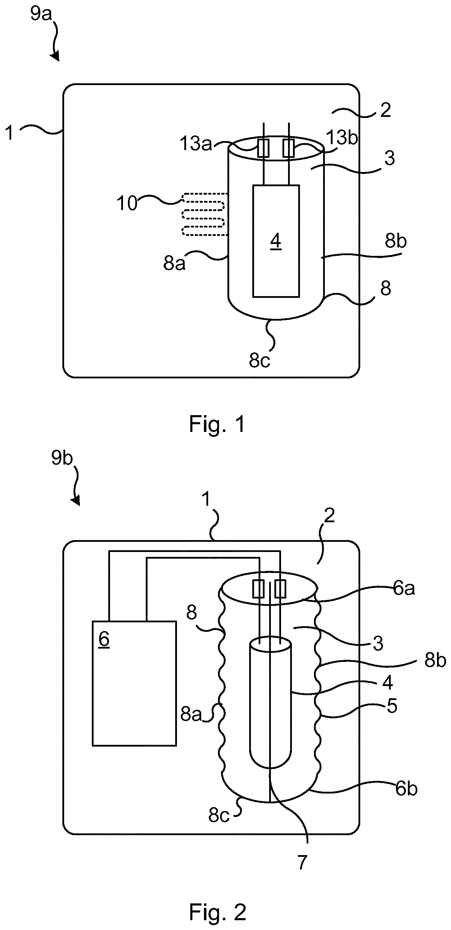

Figures 1 to 8 schematically illustrate arrangements for subsea cooling of electric equipment according to embodiments.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

Cooling systems for electric equipment, and specifically for subsea power conversion units, are used to cool down electric components, such as semiconductor modules, connectors and capacitor units. Such components generate heat that needs to be dissipated by the cooling system. The cooling systems of subsea power conversion units are usually designed in a simple manner avoiding any unnecessary parts and mechanisms. Generally it is desirable to have passive cooling systems, thus cooling systems without any driven or powered parts, such as for example without pumps, to cool down the electric equipment. In some cases natural convection is used. Natural convection helps to avoid the use of a pump but it has a low efficiency. Cooling by natural convection uses the heat transfer from the cooling liquid to the surrounding sea water to generate circulation within the cooling system and thus within the electric installation and the subsea power conversion unit.

Reference is now made to Figures 1, 2, 3, 4, and 5. Figures 1, 2, 3, 4, and 5 are cross-sectional side views illustrating arrangements 9a, 9b, 9c, 9d, 9e for subsea cooling of electric equipment.

The arrangements 9a, 9b, 9c, 9d, 9e comprise a tank 1. The tank 1 is filled with a first dielectric fluid 2. The first dielectric fluid 2 is pressurized to a pressure closer to ambient sea water pressure than to atmospheric pressure.

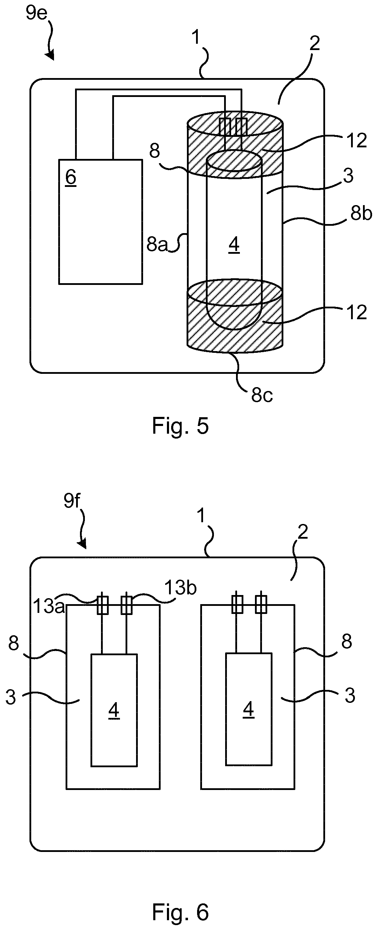

The arrangements 9a, 9b, 9c, 9d, 9e further comprise a housing 8. The housing 8 is provided in the tank 1. The housing 8 comprises a capacitor unit 4 and is filled with a second dielectric fluid 3. Electrodes 13a, 13b enable connection to the capacitor unit 4 from outside the housing 8. As will be further disclosed below with references to Fig 6, 7, and 8, the arrangement may comprise at least one housings 8, each of which comprising at least one capacitor unit 4 and being filled with the second dielectric fluid 3. The housing 8 has a surface area and a volume.

In use, electric equipment, such as capacitor units 4, generates heat. In general terms, for polymer film capacitors increased temperature is the most relevant stress after over-voltage stress. In subsea environments, such as in subsea power conversion units, which require high reliability, the thermal stress should thus be limited to a minimum. In capacitor units 4 energy is dissipated during operation. This energy is conducted to the walls of the capacitor units 4, where it is transported to the surroundings, such as to a dielectric fluid 3 surrounding the capacitor units 4. From the dielectric fluid 3 heat is transferred to the surrounding water. In more detail, heat from the second dielectric fluid 3 is transferred to the housing 8, then to the first dielectric fluid 2, then to the walls of the tank 1, and finally to the water surrounding the tank 1. Efficient cooling of the capacitor units 4 enables the capacitor hotspot temperature to be limited. For direct current (DC) link capacitors made of metalized film technology, often several windings are arranged in parallel in one container to reach the specified capacitance. For such capacitor units 4, the surface area to volume ratio may be too low to allow sufficient cooling.

The herein disclosed housing 8 therefore has a surface area to volume ratio to allow sufficient cooling. Particularly, the herein disclosed housing 8 has a surface area to volume ratio greater than 0.02 1/m. According to an embodiment the housing 8 has a surface area to volume ratio greater than 0.03 1/m, preferably greater than 0.05 1/m.

Embodiments relating to further details of the arrangements 9a, 9b, 9c, 9d, 9e for subsea cooling of electric equipment will now be disclosed.

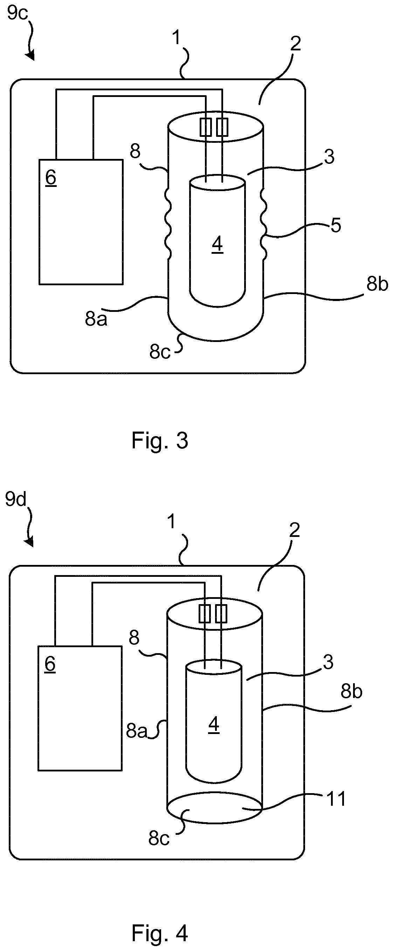

According to a first general embodiment the housing 8 may be made of metal and may have fins or a corrugated surface, to increase the surface area, and thus to enables the surface area to volume ratio to be further increased. Particularly, side walls 8a, 8b of the housing 8 may have a corrugated surface and/or a corrugated cross-section. Such an arrangement 9b is illustrated in Figure 2. Alternatively, the side walls 8a, 8b of the housing 8 at least partly form a bellows 11. Such an arrangement 9c is illustrated in Figure 3. According to one particular embodiment within the first general embodiment the arrangement 9a, 9b, 9c, 9d, 9e further comprises a heat exchanger 10. The heat exchanger 10 is in thermal contact with at least one side wall 8a, 8b of the housing 8. Such an arrangement 9a is illustrated in Figure 1. According to a second general embodiment internal cooling of the housing 8 is supported by natural convection of the second dielectric fluid 3. The second dielectric fluid 3 is at the same time used as electric insulation. Examples of the second dielectric fluid 3 include, but are not limited to: a silicone oil, an ester-based polymer fluid, a benzyltoluene based fluid, a phenylethyl benzene based fluid, a rapeseed oil, a sunflower oil, a soya oil, a castor oil, or any combinations thereof. In general terms, the second dielectric fluid 3 may be selected to ensure good cooling also at low temperatures and high pressure. Experiments have shown that, for example, silicone oil has higher thermal conductivity and more stable viscosity with both temperature and pressure compared to other dielectric liquids.

The first general embodiment and the second general embodiment may be combined for even further efficient subsea cooling of electric equipment.

A third general embodiment concerns pressure compensation with low leakage. In general terms, for pressure compensation with low leakage the surrounding of the capacitor unit 4 should be defined. According to the herein disclosed embodiments the capacitor unit 4 is operated in an electrical system in a pressure compensated tank 1. By that is generally meant that the internal pressure in the tank 1 adapts to the pressure surrounding the tank 1. As noted above the tank is filled with a first dielectric fluid 2. The compatibility of certain types of capacitor units 4, such as metalized film capacitors, is not given for all dielectric fluids. This means that capacitor units 4 of such types may not be functional over the medium-to-long term due to deterioration of the polymer film. To be able to operate also such capacitor units 4 in any dielectric fluid, the capacitor units 4 are encapsulated in a housing 8. As noted above, the housing 8 is filled with a second dielectric fluid 3. This second dielectric fluid 3 may be different or the same as first dielectric fluid 2. The housing 8 may only exhibit a negligible leakage between the two dielectric fluids (i.e., between the first dielectric fluid 2 and the second dielectric fluid 3). There may be a change in volume of the components inside the housing 8 due to change in pressure (e.g. when placing the tank 1 in a subsea environment) or due to changes in temperature of the components in the housing 8. If there is no mechanism to compensate for these volume changes (i.e., the housing 8 is rigid), the forces on the walls 8a, 8b, 8c of the housing 8 and the pressure difference between the inside and outside of the housing 8 may be high. In general terms, the leakage of fluid between the inside of the housing 8 and the outside of the housing 8 through a small leak is proportional to the pressure difference between the inside of the housing 8 and the outside of the housing 8. As such, the housing 8 will have a mechanism to compensate for the changes in volume inside the housing 8. Still, this mechanism to compensate for the change in volume inside the housing 8 may lead to relatively high pressure differences between the inside of the housing 8 and the outside of the housing 8 due to high restoring forces. The third general embodiment thus concerns pressure compensation with low leakage.

In particular, according to the third general embodiment a pressure compensating mechanism may be used to compensate for volume changes inside the housing 8. The pressure difference between the inside of the housing 8 and the outside of the housing 8 may be at most 1 bar. All mechanisms to compensate for volume changes V, where V is the volume which is to be compensated for, may be simplified using the following model. A face separating the first dielectric liquid 2 from the second dielectric liquid 3 is defined to have an area A. This face changes its position dependent on volume changes V inside the housing 8. The restoring force can be approximated by Hooke's law with spring constant *k*, where the spring constant *k* is the spring constant of the part of the housing 8 which is responsible for the restoring force wanting to bring the face (having area A) separating the dielectric liquids back to initial position. With that, the pressure difference Δ*p* is given by Δ*p* = *V·k·A*⁻²*.* The pressure compensation mechanism is chosen such that Δ*p* < 1 bar.

The third general embodiment may be combined with any of the first general embodiment and/or the second general embodiment.

A possible realization of an arrangement 9c according to the third general embodiment is shown in Figure 3. The housing 8 thus exhibits an expandable bellows 5. The bellows 5 is arranged to be expandable and contractible and thus to expand or contract depending on changes in volume of the housing 8. The area A in this case is the surface area of the bottom surface 8c of the housing 8. This realization thus also relates to the first general embodiment as disclosed above relating to efficient cooling of the capacitor unit 4. The bellows 5 itself is defined by a corrugated surface or cross section which increases the surface area of the housing 8 and thus enables efficient cooling as well as providing an efficient pressure compensation function.

Another possible realization of an arrangement 9d according to the third general embodiment is shown in Figure 4. Here, the housing 8 exhibits a membrane 11, which can bend to either the outside or the inside of the housing 8. In this case the effective area is *A*= (2/3)⁻¹ *A*_{membrane}, where *A*_{membrane} is the membrane area in un-deflected state. Thus, according to one particular embodiment within the third general embodiment a bottom wall 8c of the housing 8 forms a bendable membrane 11

Yet another possible realization of an arrangement 9b according to the third general embodiment is shown in Figure 2. Here, the housing 8 exhibits flexible side walls 8a, 8b made of polymeric or metallic foils. The side walls 8a, 8b made of foil are flexible to bend in any direction in order to adjust for the pressure change. This realization thus also relates to the first general embodiment as disclosed above relating to efficient cooling of the capacitor unit 4. The restoring forces for the housing 8 in Figure 2 may not be approximated with Hooke's law, but are typically very low. As such, the pressure difference between inside and outside the housing 8 remains below ibar.

A fourth general embodiment concerns mechanical stability of the capacitor unit 4 in or der to provide a high reliability of the arrangement. This may be particularly beneficial for arrangements where the capacitor unit 4 is arranged to be distanced from the walls 8a, 8b, 8c of the housing 8 in all directions. In general terms, *inter alia* for pressure compensating purposes the housing 8 will be filled with a second dielectric fluid 3. As a result thereof, the capacitor unit 4 inside the housing 8 may be free floating in the second dielectric fluid 3 (except from the electrodes 13a, 13b enabling connection to the capacitor unit 4 from outside the housing 8). This may create issues with reliability; the electrodes of the capacitor unit 4 may come in contact with the housing 8 resulting in unwanted electrical failures. During internal faults the capacitor unit 4 may also be disconnected from its bushing, due to shock waves.

There are different ways to stabilize the position of the capacitor unit 4 inside the housing 9. For example, the capacitor unit 4 may be fixed to a rigid element 7, such as a pipe or a bar. The rigid element 7 may be connected between a (rigid) top plate 6a and a (rigid) bottom plate 6b of the housing 8 in order to hold the capacitor unit 4 in place and improve the cooling of the capacitor unit 4. Such an arrangement 9b is illustrated in Figure 2. Additionally or alternatively, open cell foam 12 may be used to assure that the capacitor unit 4 will stay in place inside the housing 9. Thus, according to one particular embodiment within the fourth general embodiment the housing 9 comprises open cell foam 12. The open cell foam 12 covers the capacitor unit 4 in at least one direction. Such an arrangement 9e is illustrated in Figure 5. For example, the open cell foam 12 may cover the capacitor unit 4 in all directions, only in the top and/or bottom direction of the capacitor unit 4 (when being vertically oriented as in Figure 5), etc. The open cells may ensure that the second dielectric fluid 3 will penetrate through the open cell foam 12 in order to avoid voids or trapped air inside the open cell foam 12. Secondly, a solid flexible gel may be used to encapsulate the capacitor unit 4 inside the housing 8. The capacitor unit 4 may thereby be stabilized inside the cased material, whilst being flexible enough to adjust for any pressure changes.

The fourth general embodiment may be combined with any of the first general embodiment, the second general embodiment, and/or the third general embodiment.

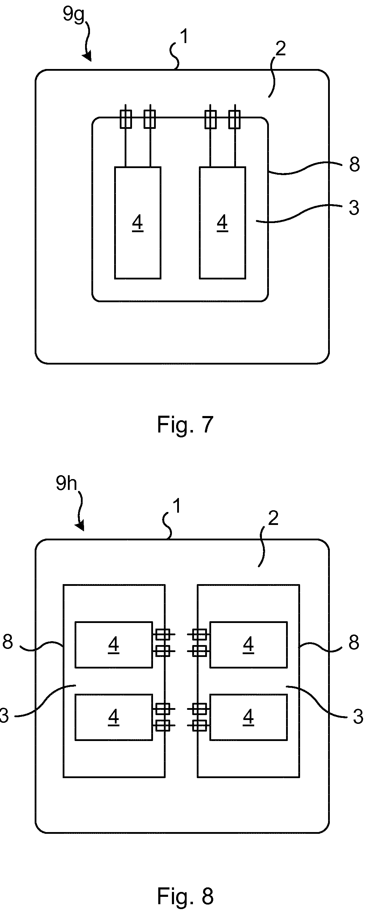

In general terms, the housing 8 may comprise at least one capacitor unit 4. Thus, the housing 8 may comprise a single capacitor unit 4 (such as in the arrangements 9a-9f of Figures 1-6) or at least two capacitor units 4 (such as in the arrangements 9g, 9h in Figures 7, 8). Further, the arrangement may comprise at least one housing 8 with features and comprising components, elements, and fluids as disclosed above. Thus, the arrangement may comprise a single housing 8 (such as in the arrangements 9a-9e of Figures 1-5) or at least two housings 8 (such as in the arrangements 9f-9h in Figures 6-8). Particularly, according to an embodiment any of the herein disclosed arrangements further comprises at least one further housing 8. Each of the at least one further housing 8 has a surface area and a volume with a surface area to volume ratio greater than 0.02 1/m. The at least one further housing 8 is provided in the tank 1. Each of at least one further housing 8 comprises at least one further capacitor unit 4 and is filled with the second dielectric fluid 3. Such arrangements 9f-9h are illustrated in Figures 6-8. For example, two or more parallel connected small capacitance capacitor units 4 may be used instead of one single large capacitance capacitor unit 4. Providing each such small capacitance capacitor unit 4 in a housing 8 of its own may enable flexible (modular) installation and also ensuring that the herein disclosed surface area to volume ratio is maintained.

According to an embodiment the capacitor units 4 are power film capacitors, in which significant losses are present. In this respect the losses are still by orders of magnitudes smaller than for power semiconductors.

Any of the herein disclosed arrangements may further comprise an electrical control system 6. The electrical control system is provided in the tank 1 and is connected to the at least one capacitor unit 4. The electrical system 6 may be provided outside the housing 8. According to an embodiment the electrical system 6 is a subsea power conversion unit.

The invention has mainly been described above with reference to a few embodiments. However, as is readily appreciated by a person skilled in the art, other embodiments than the ones disclosed above are equally possible within the scope of the invention, as defined by the appended patent claims.

## Claims

1. An arrangement (9a, 9b, 9c, 9d) for subsea cooling of electric equipment, the arrangement comprising:
a tank (1), the tank being filled with a first dielectric fluid (2);
a housing (8) having a surface area and a volume, the housing being provided in the tank, comprising a capacitor unit (4) and being filled with a second dielectric fluid (3); and
wherein pressure of the first dielectric fluid adapts to pressure surrounding the tank, **characterised in that** the housing has a surface area to volume ratio greater than 0.02 1/m, and wherein the capacitor unit (4) is arranged to be distanced from walls (8a, 8b, 8c) of the housing (8) in all directions.

2. The arrangement according to claim 1, wherein the housing has a surface area to volume ratio greater than 0.03 1/m, preferably greater than 0.05 1/m.

3. The arrangement according to claim 1, wherein side walls (8a, 8b) of the housing have a corrugated surface and/or a corrugated cross-section.

4. The arrangement according to claim 1, wherein side walls (8a, 8b) of the housing at least partly form a bellows (5).

5. The arrangement according to claim 1, wherein a bottom wall (8c) of the housing forms a bendable membrane (11).

6. The arrangement according to claim 5, wherein the membrane has a surface area A arranged to deflect a volume V, wherein V,A and k are determined such that V·k·A⁻² ≤ 1 bar, where k is a spring constant of the surface area A.

7. The arrangement according to claim 1, wherein the housing comprises open cell foam (12), the open cell foam covering the capacitor unit in at least one direction.

8. The arrangement according to claim 1, wherein the second dielectric fluid comprises at least one of a silicone oil, an ester-based polymer fluid, a benzyltoluene based fluid, a phenylethyl benzene based fluid, a rapeseed oil, a sunflower oil, a soya oil, and a castor oil.

9. The arrangement according to claim 1, wherein the housing comprises a single capacitor unit or at least two capacitor units.

10. The arrangement according to claim 1, further comprising:
a heat exchanger (10), wherein the heat exchanger is in thermal contact with at least one side wall (8a, 8b) of the housing.

11. The arrangement according to claim 1, further comprising:
an electrical control system (6), the electrical control system being provided in the tank and connected to the capacitor unit.

12. The arrangement according to claim 11, wherein the electrical system is provided outside the housing.

13. The arrangement according to claim 11 or 12, wherein the electrical system is a subsea power conversion unit.

14. The arrangement according to claim 1, further comprising:
at least one further housing (8) having a surface area and a volume, the at least one further housing being provided in the tank, comprising a further capacitor unit (4) and being filled with the second dielectric fluid (3); and
wherein the at least one further housing has a surface area to volume ratio greater than 0.02 1/m.

## Patentansprüche

1. Baugruppe (9a, 9b, 9c, 9d) zur Unterwasserkühlung elektrischer Einrichtungen, wobei die Baugruppe umfasst:
einen Tank (1), wobei der Tank mit einem ersten dielektrischen Fluid (2) gefüllt ist;
ein Gehäuse (8) mit einer Oberfläche und einem Volumen, wobei das Gehäuse in dem Tank bereitgestellt ist, eine Kondensatoreinheit (4) umfasst und mit einem zweiten dielektrischen Fluid (3) gefüllt ist; und
wobei sich Druck des ersten dielektrischen Fluids an Druck, der den Tank umgibt, anpasst, **dadurch gekennzeichnet, dass**
das Gehäuse ein Verhältnis von Oberfläche zu Volumen von größer als 0,02 1/m aufweist, und wobei die Kondensatoreinheit (4) in allen Richtungen von Wänden (8a, 8b, 8c) des Gehäuses (8) beabstandet angeordnet ist.

2. Baugruppe gemäß Anspruch 1, wobei das Gehäuse ein Verhältnis von Oberfläche zu Volumen von größer als 0,03 1/m, vorzugsweise größer als 0,05 1/m, aufweist.

3. Baugruppe gemäß Anspruch 1, wobei Seitenwände (8a, 8b) des Gehäuses eine gewellte Oberfläche und/oder einen gewellten Querschnitt aufweisen.

4. Baugruppe gemäß Anspruch 1, wobei Seitenwände (8a, 8b) des Gehäuses wenigstens teilweise einen Balg (5) bilden.

5. Baugruppe gemäß Anspruch 1, wobei eine Bodenwand (8c) des Gehäuses eine biegsame Membran (11) bildet.

6. Baugruppe gemäß Anspruch 5, wobei die Membran eine Oberfläche A aufweist, die dafür gestaltet ist, ein Volumen V auszulenken, wobei V, A und k so bestimmt sind, dass V.k.A⁻² ≤ 1 bar, wobei k eine Federkonstante der Oberfläche A ist.

7. Baugruppe gemäß Anspruch 1, wobei das Gehäuse offenzelligen Schaumstoff (12) umfasst, wobei der offenzellige Schaumstoff die Kondensatoreinheit in wenigstens einer Richtung bedeckt.

8. Baugruppe gemäß Anspruch 1, wobei das zweite dielektrische Fluid wenigstens eines von einem Siliconöl, einem Polymerfluid auf Esterbasis, einem Fluid auf Benzyltoluolbasis, einem Fluid auf Phenylethylbenzolbasis, einem Rapsöl, einem Sonnenblumenöl, einem Sojaöl und einem Castoröl umfasst.

9. Baugruppe gemäß Anspruch 1, wobei das Gehäuse eine einzige Kondensatoreinheit oder wenigstens zwei Kondensatoreinheiten umfasst.

10. Baugruppe gemäß Anspruch 1, ferner umfassend:
einen Wärmetauscher (10), wobei der Wärmetauscher in thermischem Kontakt mit wenigstens einer Seitenwand (8a, 8b) des Gehäuses steht.

11. Baugruppe gemäß Anspruch 1, ferner umfassend:
ein elektrisches Steuersystem (6), wobei das elektrische Steuersystem in dem Tank bereitgestellt und mit der Kondensatoreinheit verbunden ist.

12. Baugruppe gemäß Anspruch 11, wobei das elektrische System außerhalb des Gehäuses bereitgestellt ist.

13. Baugruppe gemäß Anspruch 11 oder 12, wobei das elektrische System eine Unterwasser-Stromumwandlereinheit ist.

14. Baugruppe gemäß Anspruch 1, ferner umfassend:
wenigstens ein weiteres Gehäuse (8) mit einer Oberfläche und einem Volumen, wobei das wenigstens eine weitere Gehäuse in dem Tank bereitgestellt ist, eine weitere Kondensatoreinheit (4) umfasst und mit dem zweiten dielektrischen Fluid (3) gefüllt ist; und
wobei das wenigstens eine weitere Gehäuse ein Verhältnis von Oberfläche zu Volumen von größer als 0,02 1/m aufweist.

## Revendications

1. Agencement (9a, 9b, 9c, 9d) pour le refroidissement sous-marin d'un équipement électrique, l'agencement comprenant :
un réservoir (1), le réservoir étant rempli avec un premier fluide diélectrique (2) ;
un boîtier (8) ayant une aire de surface et un volume, le boîtier étant disposé dans le réservoir, comprenant une unité de condensateur (4) et étant rempli avec un deuxième fluide diélectrique (3) ; et
dans lequel la pression du premier fluide diélectrique s'adapte à la pression entourant le réservoir, **caractérisé en ce que**
le boîtier a un rapport aire de surface/volume supérieur à 0,02 1/m, et dans lequel l'unité de condensateur (4) est disposée pour être éloignée de parois (8a, 8b, 8c) du boîtier (8) dans toutes les directions.

2. Agencement selon la revendication 1, dans lequel le boîtier a un rapport aire de surface/volume supérieur à 0,03 1/m, de préférence supérieur à 0,05 1/m.

3. Agencement selon la revendication 1, dans lequel des parois latérales (8a, 8b) du boîtier ont une surface ondulée et/ou une section transversale ondulée.

4. Agencement selon la revendication 1, dans lequel des parois latérales (8a, 8b) du boîtier forment au moins partiellement un soufflet (5).

5. Agencement selon la revendication 1, dans lequel une paroi inférieure (8c) du boîtier forme une membrane déformable (11).

6. Agencement selon la revendication 5, dans lequel la membrane a une aire de surface A agencée pour déformer un volume V, dans lequel V, A et k sont déterminés de telle sorte que V·k·A⁻² ≤ 1 bar, où k est une constante de rappel de l'aire de surface A.

7. Agencement selon la revendication 1, dans lequel le boîtier comprend de la mousse à cellules ouvertes (12), la mousse à cellules ouvertes recouvrant l'unité de condensateur dans au moins une direction.

8. Agencement selon la revendication 1, dans lequel le deuxième fluide diélectrique comprend au moins un élément parmi une huile de silicone, un fluide polymère à base d'ester, un fluide à base de benzyltoluène, un fluide à base de phényléthylbenzène, une huile de colza, une huile de tournesol, une huile de soja, et une huile de ricin.

9. Agencement selon la revendication 1, dans lequel le boîtier comprend une seule unité de condensateur ou au moins deux unités de condensateur.

10. Agencement selon la revendication 1, comprenant en outre :
un échangeur de chaleur (10), l'échangeur de chaleur étant en contact thermique avec au moins une paroi latérale (8a, 8b) du boîtier.

11. Agencement selon la revendication 1, comprenant en outre :
un système de commande électrique (6), le système de commande électrique étant disposé dans le réservoir et relié à l'unité de condensateur.

12. Agencement selon la revendication 11, dans lequel le système électrique est disposé à l'extérieur du boîtier.

13. Agencement selon la revendication 11 ou 12, dans lequel le système électrique est une unité de conversion de puissance sous-marine.

14. Agencement selon la revendication 1, comprenant en outre :
au moins un autre boîtier (8) ayant une aire de surface et un volume, l'au moins un autre boîtier étant disposé dans le réservoir, comprenant une autre unité de condensateur (4) et étant rempli avec le deuxième fluide diélectrique (3) ; et
dans lequel l'au moins un autre boîtier a un rapport aire de surface/volume supérieur à 0,02 1/m.
